Europäisches Patentamt

European Patent Office

Office européen des brevets

(19)

(11) **EP 0 851 585 A1**

(12) **EUROPEAN PATENT APPLICATION**

(43) Date of publication:
01.07.1998 Bulletin 1998/27

(51) Int. Cl.$^6$: **H03K 17/284**, H03K 17/14,
G05F 3/24

(21) Application number: 96830650.6

(22) Date of filing: 24.12.1996

(84) Designated Contracting States:
AT BE CH DE DK ES FI FR GB GR IE IT LI LU MC
NL PT SE
Designated Extension States:
AL LT LV RO SI

(71) Applicant:
SGS-THOMSON MICROELECTRONICS s.r.l.
20041 Agrate Brianza (Milano) (IT)

(72) Inventor: Milanesi, Andrea
15052 Casalnoceto (Alessandria) (IT)

(54) **Circuit for generating an electric signal of constant duration, said duration being independant of temperature and process variations**

(57) A circuit for the generation of an electrical signal of constant duration comprises a capacitor (C), a constant current generator for charging said capacitor and a voltage comparator (COMP) to compare the voltage present at the terminals of the capacitor with a reference voltage ($V_{ref}$) and supply at output a digital signal (OUT) dependent upon the voltage across the capacitor; the constant current generator comprises a transistor (M1) biased with a voltage ($V_{gsx}$) between gate and source obtained as the difference between the sum of two gate-source voltages of two transistors (M2,M3) and a gate-source voltage of another transistor (M4).

Fig. 3

## Description

The present invention relates to a circuit for the generation of an electrical signal of constant duration.

Field of application

Specifically the present invention relates to a circuit comprising a capacitor, a current generator to charge the capacitor with a constant current and a voltage comparator to compare the voltage present at the terminals of the capacitor with a reference voltage and supply at output a logical signal depending on the voltage at the terminals of the capacitor.

Upon power up of the circuit the capacitor is discharged and the output of the comparator holds a first logical level, e.g. of zero volt. Subsequently the current generator initiates charging of the capacitor and the voltage at its terminals increases until it reaches a threshold value of the comparator causing commutation of the output on a second logical level.

The capacitance of the capacitor and the value of the charge current determine the duration of the signal generated and consequently their accuracy affects the accuracy of the circuit.

Prior art

A known solution for generation of a constant current provides for the use of an appropriately biased MOS transistor.

Indeed, by applying a biasing voltage between the gate and source terminals the transistor is caused to conduct a constant current between the source and drain terminals.

As known, there exists a biasing voltage $V_{gs} = V_{gsx}$ of the gate of an MOS transistor for which the drain current is constant with temperature variation:

$$I_D = \mu \cdot C_{OX} \cdot (V_{gs} - V_{th})^2 \qquad (1.1)$$

Where $\mu$ is the mobility of electrons, $C_{OX}$ is the capacitance of the silicon oxide, $V_{gs}$ is the gate biasing voltage and $V_{th}$ is the threshold voltage of the MOS transistor.

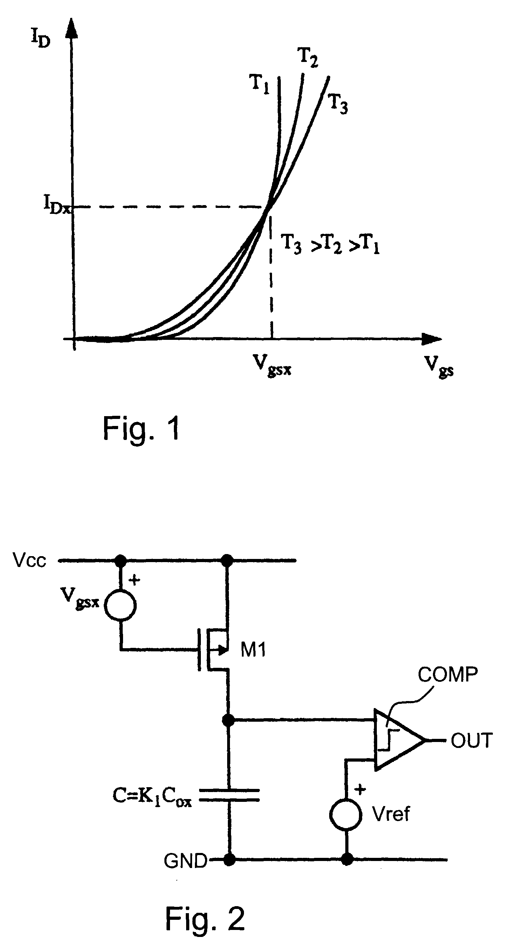

This relationship can be readily deduced by observing the drain current $I_D$ as a function of the $V_{gs}$ with different temperatures as illustrated in FIG 1 which shows the current-voltage characteristics of an MOS transistor with three different temperatures T1, T2 and T3.

As may be seen in that figure there is a point on the chart corresponding to a voltage $V_{gsx}$ at which the three curves intersect. This relationship leads to the assumption that by using this current to charge a capacitor there could be provided an electrical signal of constant duration with temperature change of the device.

In reality the problem is not so simple since $C_{OX}$, $V_{th}$ and $\mu$ vary with the process in addition to varying with the temperature.

The mobility of $\mu$ varies very little with the process because it is one of the best-controlled parameters and, indeed, it depends mainly on the doping element and is known with an accuracy of less than 5%, the mobility can thus be considered dependent on temperature alone in a first approximation.

The problem goes back to compensating the error introduced by the variation in the gate oxide thickness and the threshold voltage.

The prior art eliminates dependence on $C_{OX}$ by using as capacitance a capacitor whose dielectric is the same gate oxide used in the transistors. In this manner the relationship between MOS current and capacitance becomes:

$$\frac{I_D}{C} = \frac{I_D}{K_1 \cdot C_{OX}} = \frac{\mu \cdot C_{OX} \cdot (V_{gsx} - V_{th})^2}{K_1 \cdot C_{OX}} = \frac{\mu \cdot (V_{gsx} - V_{th})^2}{K_1} \qquad (1.2)$$

where $K_1$ is a constant area factor.

A known circuit diagram which permits providing an electrical signal by this method is shown in FIG 2.

In FIG 2 a capacitor C is connected between a ground reference voltage GND and a constant current generator consisting essentially of an MOS transistor M1 biased with a voltage $V_{gsx}$ between the gate and source terminals. The voltage present on the capacitor C is applied to a first input terminal of a voltage comparator COMP while a second input thereof is connected to a reference voltage $V_{ref}$. The comparator COMP then compares the voltage at the terminals of the capacitor with the reference $V_{ref}$ and supplies at output a logical signal which is the result of the comparison.

One disadvantage of this circuit is that the $I_D/C_{OX}$ ratio is strongly dependent upon the threshold voltage of the transistor M1 since a variation of the threshold causes the transistor being no longer correctly biased. Consequently the $I_D/C_{OX}$ ratio also varies with temperature.

The technical problem underlying the present invention is to make available a circuit for the generation of an electrical signal of constant duration and independent of temperature and process variables to overcome the limitations indicated above with reference to the prior art.

The technical problem is solved by a circuit of the type indicated above and defined in the characterizing part of claims 1 to 6.

## Summary of the invention

The solution idea underlying the present invention is to provided a circuit for the generation of an electrical signal of constant duration of the type comprising a capacitor, a constant current generator for charging the capacitor, and a voltage comparator to compare the voltage present at the terminals of the capacitor with a reference voltage and supply at output a digital signal dependent upon the voltage at the terminals of the capacitor, in which the current generator comprises a MOS transistor biased with a voltage $V_{gsx}$ between gate and source obtained as the difference between the sum of two gate-source voltages of two MOS transistors and a gate-source voltage of another MOS transistor.

The characteristics and advantages of the method in accordance with the present invention are set forth in the description of an embodiment thereof given below by way of non-limiting example with reference to the annexed drawings.

## Brief description of the drawings

FIG 1 shows in a chart the current-voltage characteristics of a MOS transistor with three different temperatures,

FIG 2 shows a diagram of a constant duration electrical signal generation circuit of a known type,

FIG 3 shows a circuit diagram of a first circuit for the generation of a constant duration electrical signal independent of temperature and process variables and provided in accordance with the present invention,

FIG 4 shows a circuit diagram of a second circuit for generation of a constant duration electrical signal independent of temperature and process variables and provided in accordance with the present invention, and

FIG 5 shows a circuit diagram of a third circuit for the generation of a constant duration electrical signal independent of temperature and process variables and provided in accordance with the present invention.

## Detailed description

Assuming that the specific capacitance of the gate oxide $C_{OX}$ be constant with temperature variation, from the relationship (1.1) on the drain current of the MOS transistor it can be deducted that there is a gate voltage $V_{gs} = V_{gsx}$ such that:

$$\frac{I_D}{C_{OX}} = \mu \cdot (V_{gsx} - V_{th})^2 = Cost \tag{1.3}$$

where mobility varies with the temperature proportionately to a factor

$$\left(\frac{T}{T_0}\right)^{-\frac{3}{2}},$$

while the threshold voltage $V_{th}$ varies with the temperature in such a manner as to compensate the mobility variations.

$V_{th}$ is however a process variable which depends on the quantity of doping agent, the oxide thickness and the quality of the oxide-semiconductor interface, hence the relationship (1.3) can no longer be true with variation of the process parameters.

To keep this relationship valid it is necessary to bias the MOS with a $V_{gsx}$ dependent upon the process variables.

Let us consider

$$V_{gsx} = \Delta V_0 + V_{th0}$$

as the biasing voltage,
where $V_{tho}$ is the threshold voltage of the process at ambient temperature 25°C and $\Delta V_o$ is a constant voltage and

$$V_{th} = V_{th0} + \frac{\Delta V_{th}}{\Delta T} \cdot (T - 25)$$

where $\Delta V_{th}/\Delta T$ is the variation of the threshold with temperature.
Substituting both the expressions in (1.3) we find:

$$\frac{I_D}{C_{OX}} = \mu \cdot \left[ \Delta V_0 + V_{th0} - V_{th0} - \frac{\Delta V_{th}}{\Delta T} \cdot (T - 25) \right]^2 = Cost$$

from which is extracted:

$$\frac{I_D}{C_{OX}} = \mu \cdot \left[ \Delta V_0 - \frac{\Delta V_{th}}{\Delta T} \cdot (T - 25) \right]^2 = Cost \qquad (1.4)$$

In this last relationship dependence on the threshold voltage has been eliminated. There appear only two values $\Delta V_o$ and $(\Delta V_{th}/\Delta T)$ which are independent of the process variables.

The present invention consists of the electrical circuit which provides this last compensation by biasing the gate of the MOS transistor with a voltage $V_{gsx} = \Delta V_o + V_{tho}$ which makes the $I_D/C_{OX}$ ratio independent of the threshold voltage and temperature variations.

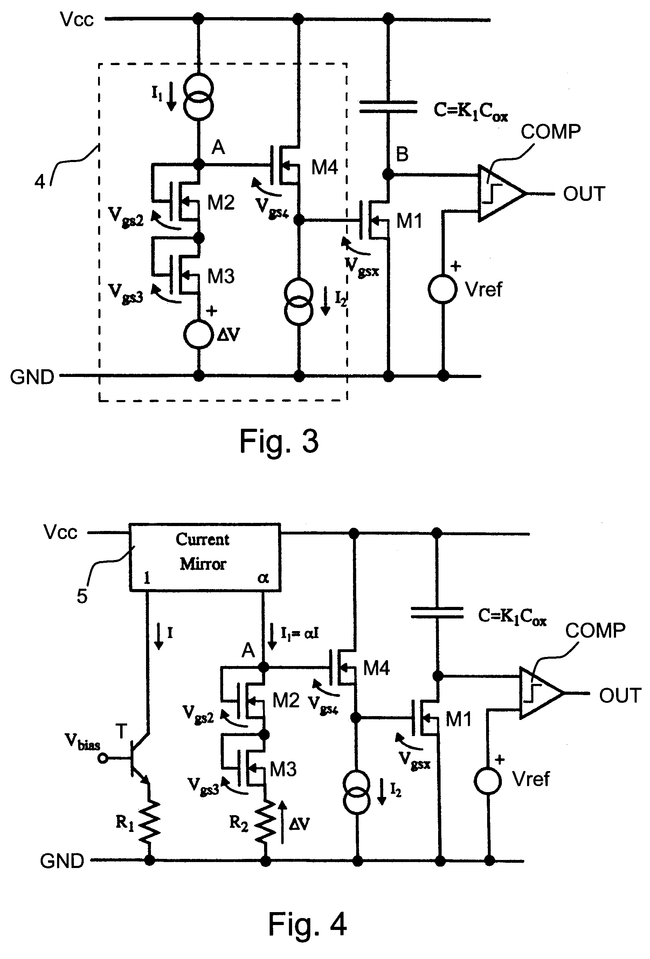

A circuit in which this compensation is implemented is shown in detail in FIG 3.

A capacitor C is connected between a first terminal $V_{cc}$ of a supply voltage generator and a constant current generator consisting essentially of a first MOS transistor M1 and a reference biasing network 4.

The transistor M1 has a gate terminal G connected to the biasing network 4, a drain terminal D connected, in a common node B, to a capacitor terminal C, and a source terminal S connected to a second terminal (GND) of the supply voltage generator, in particular a ground reference.

A comparator COMP has a first input coupled to the node B and a second input connected to a reference voltage $V_{ref}$. The voltage on the node B, which depends on the charge status of the capacitor C, is compared by the comparator with the reference voltage $V_{ref}$ and a logical output signal OUT changes state when the voltage on the capacitor exceeds the reference voltage. In this manner the output signal OUT remains at a first logic level for a precise and well defined period of time to then switches to a second logic level.

The biasing network 4 is made up of two distinct legs. A first leg comprises a second M2 and a third M3 transistor connected in diode configuration, i.e. each having its gate and source terminals joined to its drain terminal, and connected together in series between a current generator I1 and a reference voltage $\Delta V$.

A second leg comprises a fourth transistor M4 having a main source-drain conduction path connected in series with a current generator $I_2$. Both legs are connected between the terminals $V_{cc}$ and GND of the power supply generator.

The fourth transistor M4 has a gate terminal connected to the common node A between the current generator I1 and the drain terminal of the second transistor M2, a drain terminal connected to the power supply terminal $V_{cc}$ and a source terminal connected to the current generator I2 and to the gate terminal of the first transistor M1.

The reference voltage $\Delta V$ is a voltage generator connected between the source terminal of the third transistor M3 and the terminal GND of the power supply generator.

The idea is to obtain the threshold voltage $V_{tho}$ of the MOS transistor by subtracting from the sum of the $V_{gs}$ of the transistors M2 and M3, the $V_{gs}$ of the transistor M4 which must have an overdrive equal to the sum of the overdrives of the transistors M2 and M3. This result can be obtained as explained below by appropriately sizing the currents and transistors.

With reference to FIG 3 we have:

$$V_{gsx} = \Delta V + V_{gs\,2} + V_{gs\,3} - V_{gs\,4} \tag{1.5}$$

if we consider that:

$$V_{gs} = V_{th} + overdrive = V_{th} + \sqrt{\frac{L \cdot I_D}{2 \cdot \mu \cdot C_{OX} \cdot W}}$$

where L and W are the physical dimensions of the transistor and substituting this expression in the previous equation (1.5) we have:

$$V_{gsx} = \Delta V + V_{th} + \sqrt{\frac{L_2 \cdot I_1}{2 \cdot \mu \cdot C_{OX} \cdot W_2}} + \sqrt{\frac{L_3 \cdot I_1}{2 \cdot \mu \cdot C_{OX} \cdot W_3}} + - \sqrt{\frac{L_4 \cdot I_2}{2 \cdot \mu \cdot C_{OX} \cdot W_4}} \tag{1.6}$$

In order that the overdrives compensate each other there must be:

$$\sqrt{\frac{L_2 \cdot I_1}{2 \cdot \mu \cdot C_{OX} \cdot W_2}} + \sqrt{\frac{L_3 \cdot I_1}{2 \cdot \mu \cdot C_{OX} \cdot W_3}} - \sqrt{\frac{L_4 \cdot I_2}{2 \cdot \mu \cdot C_{OX} \cdot W_4}} \tag{1.7}$$

(1.7) is considerably simplified if

$$\frac{L_2}{W_2} = \frac{L_3}{W_3}$$

and in this case it is reduced to:

$$4 \cdot I_1 \cdot \frac{L_2}{W_2} = I_2 \cdot \frac{L_4}{W_4} \tag{1.8}$$

This allows finding a biasing voltage $V_{gsx} = \Delta V + V_{th}$ in which however $V_{th}$ varies with temperature. It is therefore necessary to arrange that $\Delta V$ compensate this variation:

$$V_{gsx} = \Delta V + V_{th} = \Delta V + V_{th\,0} + \frac{\Delta V_{th}}{\Delta T} \cdot (T - 25) = \Delta V_0 + V_{th0}$$

For this last equality be true, $\Delta V$ must be:

$$\Delta V = \Delta V_0 - \frac{\Delta V_{th}}{\Delta T} \cdot (T - 25) \tag{1.9}$$

An example of application in which this voltage is provided is the circuit shown in FIG 4. This circuit uses as current generator a current mirror 5 having a primary leg and a secondary leg.

In the primary leg a current I is forced through a bipolar transistor T biased with a current $V_{bias}$ and placed in series with a resistor R1 while in the secondary leg flows a current $I_1 = \alpha \cdot I$ equal to $\alpha$ times the current I.

The voltage $\Delta V$ is provided as a voltage drop on a resistor R2 placed in series with the two transistors M2 and M3. From the same circuit can be taken the behaviour of $\Delta V$ with temperature variation:

$$\Delta V = \alpha \cdot I \cdot R_2 = \alpha \cdot R_2 \cdot \frac{V_{bias} - V_{be\,0} - \frac{\Delta V_{be}}{\Delta T} \cdot (T - 25)}{R_1}$$

from which is found:

$$\Delta V = \frac{\alpha \cdot R_2}{R_1} \cdot (V_{bias} - V_{be\,0}) - \frac{\alpha \cdot R_2}{R_1} \cdot \frac{\Delta V_{be}}{\Delta T} \cdot (T - 25) \qquad (1.10)$$

From this and from (1.9) it is deduced that:

$$\Delta V_0 = \frac{\alpha \cdot R_2}{R_1} \cdot (V_{bias} - V_{be\,0})$$

and that

$$\frac{\Delta V_{th}}{\Delta T} = \frac{\alpha \cdot R_2}{R_1} \cdot \frac{\Delta V_{be}}{\Delta T}$$

Setting two parameters, e.g. $\alpha$ and $R_1$, it is possible to find the other two, the value of the resistor R2 and the biasing voltage of the transistor $V_{bias}$.

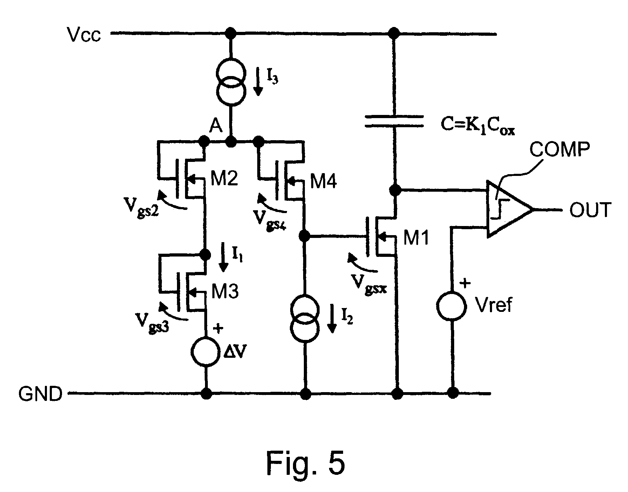

The scheme for biasing the transistors M2, M3 and M4 shown in FIGS 3 and 4 is of course not the only one possible. The circuit shown in FIG 5 is an example thereof. This circuit differs from the circuit of FIG 3 only in the connection of the transistor M4. Indeed, the drain terminal of this transistor is connected to its own gate terminal in the common node A in which is applied the current of the generator I1. The important point is control of the biasing currents of the MOS transistors.

## Claims

1. Circuit for the generation of an electrical signal of constant duration and independent of temperature and process variables of the type comprising a capacitor (C), a constant current generator for charging the capacitor and a voltage comparator (COMP) to compare the voltage present across the capacitor with a reference voltage ($V_{ref}$) and supply at output a digital signal (OUT) dependent upon the voltage across the capacitor (C) with said constant current generator comprising a first MOS transistor (M1) having a gate terminal, a source terminal and a drain terminal, biased with a fixed voltage ($V_{gsx}$) between gate and source to conduct a certain current between drain and source and characterized in that said fixed voltaged is obtained as the difference between the sum of two gate-source voltages (Vgs2 e Vgs3) of a second (M2) and a third (M3) MOS transistors and a gate-source voltage (Vgs4) of a fourth MOS transistor (M4) .

2. Circuit in accordance with claim 1 and characterized in that said second (M2) and third (M3) transistors are connected in diode configuration with each having its gate terminal joined to its drain terminal and are connected together in series between a first current generator (I1) and a reference voltage ($\Delta V$).

3. Circuit in accordance with claim 2 and characterized in that the fourth transistor (M4) has a gate terminal connected to the common node (A) between the first current generator (I1) and the drain terminal of the second transistor (M2) with a drain terminal connected to a power supply terminal ($V_{cc}$) and a source terminal connected to a second current generator (I2) and to the gate terminal of the first transistor (M1) .

4. Circuit in accordance with claim 2 and characterized in that the reference voltage ($\Delta V$) is a voltage generator connected between the source terminal of the third transistor (M3) and a ground reference voltage (GND).

5. Circuit in accordance with claim 4 and characterized in that the voltage generator is provided by means of a resistor (R2) connected between the source terminal of the third transistor (M3) and a ground reference voltage (GND).

6. Circuit in accordance with claim 5 and characterized in that the first current generator (I1) is a secondary leg of a current mirror (5) in which flows a current ($\alpha \cdot I$) directly proportionate to the current (I) running in the primary leg of the same current mirror (5).

Fig. 1

Fig. 2

Fig. 3

Fig. 4

Fig. 5

European Patent Office

**EUROPEAN SEARCH REPORT**

Application Number

EP 96 83 0650

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | US 4 642 552 A (SUZUKI TOSHIRO ET AL) 10 February 1987 <br> * the whole document * <br> --- | 1-6 | H03K17/284 <br> H03K17/14 <br> G05F3/24 |
| A | GB 2 071 955 A (PHILIPS NV) 23 September 1981 <br> * the whole document * <br> --- | 1 | |
| A | IBM TECHNICAL DISCLOSURE BULLETIN, <br> vol. 35, no. 7, 1 December 1992, <br> pages 197-198, XP000332979 "DELAYED POWER-ON CIRCUIT WITH SOFT START" <br> * the whole document * <br> --- | 1 | |
| A | PATENT ABSTRACTS OF JAPAN <br> vol. 009, no. 266 (E-352), 23 October 1985 <br> & JP 60 113521 A (FUJITSU KK), 20 June 1985, <br> * abstract * <br> --- | 1 | |
| A | US 4 199 693 A (BENNETT ALTON W) 22 April 1980 <br> * the whole document * <br> --- | 1 | TECHNICAL FIELDS SEARCHED (Int.Cl.6) <br><br> H03K <br> G05F |
| A | EP 0 565 806 A (-) 20 October 1993 <br> * the whole document * <br> --- | 1 | |
| A | US 4 119 869 A (HASHIMOTO MASARU) 10 October 1978 <br> * the whole document * <br> ----- | 1 | |

The present search report has been drawn up for all claims

| Place of search | Date of completion of the search | Examiner |
|---|---|---|
| THE HAGUE | 29 May 1997 | Jepsen, J |